# FASCICULE DE BREVET EUROPEEN

(11) **EP 0 999 292 B1**
(45) Date de publication et mention de la délivrance du brevet: **06.06.2007**
(21) Numéro de dépôt: 99402603.7
(22) Date de dépôt: 21.10.1999
(51) Int. Cl.: C23C 16/44, F16L 59/06

(54) **Transport de gaz pompés dans une pompe à vide ou des canalisations**
Beförderung von in einer Vakuumpumpe oder in Leitungen gepumpten Gasen
Transport of gases pumped in a vacuum pump or in pipings

(30) Priorité: 02.11.1998 FR 9813727
(43) Date de publication de la demande: 10.05.2000
(73) Titulaire: Alcatel Lucent, 75008 Paris (FR)
(72) Inventeur: Houze, Francois, 74350 Cuvat (FR)
(74) Mandataire: Lamoureux, Bernard

(56) Documents cités:
- EP-A- 0 358 005
- DE-A- 3 003 798
- GB-A- 2 040 011
- US-A- 3 846 574
- US-A- 5 817 575
- PATENT ABSTRACTS OF JAPAN vol. 95, no. 4, 31 mai 1995 (1995-05-31) & JP 07 012291 A (MATSUSHITA ELECTRIC IND CO LTD), 17 janvier 1995 (1995-01-17)

## Description

La présente invention concerne les dispositifs de génération de vide comprenant au moins une pompe à vide associée à une canalisation d'aspiration et à une canalisation de refoulement.

L'une des utilisations fréquentes des pompes à vide est la génération du vide dans une enceinte de traitement de semi conducteurs.

Lors d'un tel traitement, on effectue des dépôts de matières sur une tranche de semi conducteur. Le rendement des dépôts est relativement faible, et la pompe à vide aspire une grande partie des matières que l'on veut déposer sur le semi conducteur. Lorsque la pompe à vide refoule à pression atmosphérique ou à pression relativement haute, les gaz pompés tendent à se condenser et à se solidifier lorsque leur température est trop basse, ce qui peut perturber l'efficacité de la pompe.

Ce phénomène se produit essentiellement au refoulement des pompes primaires, là où la pression est élevée et où les gaz se refroidissent rapidement au sortir du corps de la pompe.

Ce problème apparaît également dans les canalisations d'aspiration, en amont de la pompe, mais dans une moindre mesure.

Pour limiter les dépôts, les solutions actuelles, par exemple le dispositif du brevet US 5,817,575, consistent essentiellement à chauffer les canalisations afin d'éviter les points froids, lieux préférentiels des condensations et solidifications des gaz.

Ces solutions nécessitent un apport supplémentaire d'énergie, et leur efficacité est variable en fonction des gaz pompés et des conditions de vide.

Le problème proposé par la présente invention est de concevoir de nouveaux moyens permettant d'éviter efficacement la condensation et la solidification des gaz pompés dans les zones haute pression des pompes à vide, sans recourir à un apport d'énergie extérieur pour chauffer les canalisations.

Un autre objet de l'invention est de concevoir de tels moyens permettant simultanément de réduire le bruit émis par le dispositif de génération de vide, en évitant la propagation des ondes sonores.

L'invention résulte de l'observation selon laquelle l'isolation très efficace d'une canalisation de pompe à vide, par une couche de vide interposée entre la canalisation et l'atmosphère ambiante, est suffisante pour maintenir la canalisation à une température appropriée évitant tous risques de condensation et de solidification des gaz pompés. Et la couche de vide assure simultanément une isolation phonique efficace, s'opposant à la propagation des ondes sonores vers l'extérieur.

Ainsi, pour atteindre ces objets ainsi que d'autres, un dispositif de génération de vide selon l'invention comprend au moins une pompe à vide associée à une canalisation d'aspiration et à une canalisation de refoulement, une portion au moins du dispositif de génération de vide étant séparée de l'atmosphère extérieure par un volume dans lequel règne un vide approprié.

Selon un premier mode de réalisation, ledit volume dans lequel règne un vide approprié est étanche, et conserve ainsi ledit vide approprié de manière permanente.

Selon un autre mode de réalisation, ledit volume dans lequel règne un vide approprié est relié à une source de vide extérieure, qui entretien ainsi ledit vide approprié.

Dans ce cas, on peut avantageusement mettre à profit l'application de la solution à un dispositif de génération de vide : on utilise alors comme source de vide extérieure le dispositif de génération de vide lui-même.

En pratique, pour créer ledit volume dans lequel règne un vide approprié, on peut prévoir une double paroi étanche constituée de deux parois séparées l'une de l'autre, et ledit volume occupe l'espace entre les deux parois de la double paroi étanche.

En alternative, on peut prévoir une simple paroi autour du dispositif de génération de vide ; dans ce cas, ledit volume dans lequel règne le vide approprié occupe l'espace entre la paroi externe étanche et une portion du dispositif de génération de vide.

Selon une première application, ledit volume dans lequel règne un vide approprié est réalisé autour de la canalisation de refoulement d'une pompe à vide primaire, pour s'opposer à la condensation et à la solidification des gaz pompés, et pour réduire le bruit émis.

Selon une autre application, ledit volume dans lequel règne un vide approprié entoure des dispositifs internes d'amortissement acoustique des pulsations de pression et ondes sonores (silencieux, pièges à sons...).

Selon une autre application, ledit volume dans lequel règne un vide approprié entoure un élément de canalisation d'aspiration ou intermédiaire dans le dispositif de génération de vide. On peut ainsi éviter la condensation et la solidification des gaz pompés dans les zones où ce phénomène risque de se produire.

Selon une autre application, ledit volume dans lequel règne un vide approprié entoure la pompe à vide elle-même. Cette utilisation permet de limiter le bruit émis par la pompe à vide.

D'autres objets, caractéristiques et avantages de la présente invention ressortiront de la description suivante de modes de réalisation particuliers, faite en relation avec les figures jointes, parmi lesquelles:
- la figure 1 illustre une première application de l'invention, adaptée à une canalisation pour le transport de gaz pompés au moyen d'une pompe à vide ;
- la figure 2 illustre une seconde application de l'invention à une canalisation de refoulement de gaz pompés par pompe à vide munie de dispositifs internes d'amortissement acoustique des pulsations de pression ;
- la figure 3 illustre une troisième application de l'invention pour l'isolation d'une pompe à vide ; et
- la figure 4 illustre une variante selon l'invention pour l'isolation d'une pompe à vide.

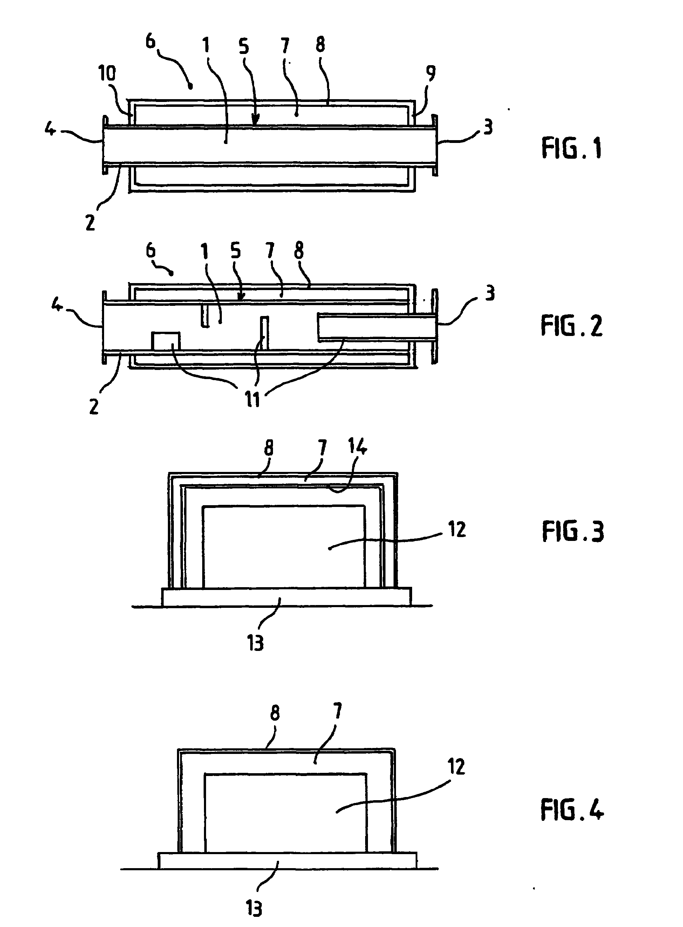

Dans le mode de réalisation illustré sur la figure 1, une portion de canalisation 1 est formée d'un tube 2 cylindrique dont les deux extrémités 3 et 4 sont ouvertes, et dont la surface latérale 5 est isolée de l'atmosphère extérieure 6 par un volume 7 dans lequel règne un vide approprié. Dans ce cas, le volume 7 occupe l'espace entre une paroi externe étanche 8 et le tube 2. La paroi externe étanche 8 est un tronçon tubulaire cylindrique de diamètre supérieur à celui du tube 2, disposé coaxialement le long du tube 2 et ayant deux flasques d'extrémité 9 et 10 qui le relient de manière étanche à la paroi latérale du tube 2 au voisinage de ses extrémités 3 et 4.

En réalisant autour du volume 7 une étanchéité suffisante grâce à la paroi externe étanche 8 et à son raccordement étanche sur la paroi périphérique du tube 2, on peut réaliser le vide approprié dans le volume 7 et ce vide est conservé de manière permanente.

En alternative, on peut avantageusement relier le volume 7 à une source de vide extérieure qui entretient le vide approprié. Cette source de vide extérieure peut avantageusement être la pompe à vide elle-même qui est associée à la canalisation 1.

Dans le mode de réalisation de la figure 2, on retrouve les mêmes éléments que dans le mode de réalisation de la figure 1, à savoir la canalisation 1 formée d'un tube 2 entre deux extrémités ouvertes 3 et 4, et avec une paroi externe étanche 8 entourant la surface latérale 5 pour délimiter un volume 7 dans lequel règne un vide approprié.

Dans ce cas, la canalisation 1 est une canalisation de refoulement en sortie d'une pompe à vide, et comprend des dispositifs internes 11 d'amortissement acoustique des pulsations de pression.

Dans les modes de réalisation des figures 1 et 2, la paroi externe étanche 8 est une simple paroi, et le volume 7 dans lequel règne un vide approprié est situé entre la paroi externe étanche 8 et la portion de dispositif de génération de vide constituée par le tube 2 de la canalisation 1.

En alternative, on peut entourer la surface latérale 5 du tube 2 avec une double paroi étanche, l'espace situé entre les deux parois de la double paroi étanche étant occupé par le volume dans lequel règne un vide approprié.

Dans le mode de réalisation de la figure 3, on a illustré l'application de l'invention à une pompe à vide 12. La pompe à vide 12, reposant sur un socle 13, est recouverte d'un capotage double paroi constitué d'une paroi externe étanche 8 et d'une paroi interne étanche 14 séparée de la paroi externe étanche 8 pour définir un volume 7 dans lequel règne un vide approprié. On réduit ainsi les risques de condensation et de solidification des gaz dans les étages intermédiaires de la pompe à vide 12, et on réduit simultanément le bruit émis par la pompe à vide 12.

Dans le mode de réalisation de la figure 4, la pompe à vide 12, reposant sur son socle 13, est recouverte d'une paroi externe étanche 8 séparée de la pompe à vide 12 par un espace définissant un volume étanche 7 dans lequel règne un vide approprié. Les avantages sont les mêmes que ceux obtenus par le mode de réalisation de la figure 3.

Dans les deux modes de réalisation, on peut prévoir une étanchéité suffisante de la paroi externe étanche 8 pour que le vide établi dans le volume 7 se conserve de manière permanente.

En alternative, le volume 7 est relié à une source de vide extérieure qui entretient ledit vide approprié, la source de vide pouvant être la pompe à vide 12 elle-même.

On prévoit des passages étanches assurant la fourniture des servitudes nécessaires au fonctionnement de la pompe à vide 12, par exemple les raccordements vide, électricité, eau, air comprimé, azote, information capteur, etc.

La pompe à vide peut être refroidie à l'eau, de façon traditionnelle.

## Revendications

1. - Dispositif de génération de vide comprenant au moins une pompe à vide (12) associée à une canalisation d'aspiration et à une canalisation de refoulement (1), **caractérisé en ce qu**'une portion au moins (1, 12) du dispositif de génération de vide est séparée de l'atmosphère extérieure (6) par un volume (7) dans lequel règne un vide approprié.

2. - Dispositif selon la revendication 1, **caractérisé en ce que** ledit volume (7) dans lequel règne un vide approprié est étanche et conserve ainsi ledit vide approprié de manière permanente.

3. - Dispositif selon la revendication 1, **caractérisé en ce que** ledit volume (7) dans lequel règne un vide approprié est relié à une source de vide extérieure qui entretient ledit vide approprié.

4. - Dispositif selon la revendication 3, **caractérisé en ce que** la source de vide extérieure est ledit dispositif de génération de vide (12).

5. - Dispositif selon l'une quelconque des revendications 1 à 4, **caractérisé en ce que** ledit volume (7) dans lequel règne un vide approprié occupe l'espace entre les deux parois (8, 14) d'une double paroi étanche.

6. - Dispositif selon l'une quelconque des revendications 1 à 4, **caractérisé en ce que** ledit volume (7) dans lequel règne un vide approprié occupe l'espace entre une paroi externe étanche (8) et ladite portion (1, 12) du dispositif de génération de vide.

7. - Dispositif selon l'une quelconque des revendications 1 à 6, **caractérisé en ce que** ledit volume (7) dans lequel règne un vide approprié est réalisé autour de la canalisation de refoulement (1) de la pompe à vide, pour s'opposer à la condensation et à la solidification des gaz pompés, et pour réduire le bruit émis.

8. - Dispositif selon la revendication 7, **caractérisé en ce que** la canalisation de refoulement (1) comprend en outre des dispositifs internes (11) d'amortissement acoustique des pulsations de pression.

9. - Dispositif selon l'une quelconque des revendications 1 à 8, **caractérisé en ce que** ledit volume (7) dans lequel règne un vide approprié entoure un élément de canalisation d'aspiration ou intermédiaire dans le dispositif de génération de vide.

10. - Dispositif selon l'une quelconque des revendications 1 à 9, **caractérisé en ce que** ledit volume (7) dans lequel règne un vide approprié entoure la pompe à vide (12), pour limiter le bruit émis par la pompe.

## Claims

1. A vacuum-generating device comprising at least one vacuum pump (12) associated with a suction pipe and with a delivery pipe (1), said device being **characterized in that** at least a portion (1, 12) of the vacuum-generating device is separated from the outside atmosphere (6) by a volume (7) in which a suitable vacuum prevails.

2. A device according to claim 1, **characterized in that** said volume (7) in which a suitable vacuum prevails is gastight thereby maintaining said suitable vacuum permanently.

3. A device according to claim 1, **characterized in that** said volume (7) in which a suitable vacuum prevails is connected to an external vacuum source which sustains said suitable vacuum.

4. A device according to claim 3, **characterized in that** the external vacuum source is said vacuum-generating device (12).

5. A device according to any one of claims 1 to 4, **characterized in that** said volume (7) in which a suitable vacuum prevails occupies the space between the two walls (8, 14) of a gastight double wall.

6. A device according to any one of claims 1 to 4, **characterized in that** said volume (7) in which a suitable vacuum prevails occupies the space between a gastight outer wall (8) and said portion (1, 12) of the vacuum-generating device

7. A device according to any one of claims 1 to 6, **characterized in that** said volume (7) in which a suitable vacuum prevails is formed around the delivery pipe (1) of the vacuum pump, so as to prevent the pumped gases from condensing and solidifying, and so as to reduce the noise given off.

8. A device according to claim 7, **characterized in that** the delivery pipe (1) is further provided with internal devices (11) for acoustically damping the pulsating pressure.

9. A device according to any one of claims 1 to 8, **characterized in that** said volume (7) in which a suitable vacuum prevails surrounds an intermediate or suction pipe element in the vacuum-generating device.

10. A device according to any one of claims 1 to 9, **characterized in that** said volume (7) in which a suitable vacuum prevails surrounds the vacuum pump (12), so as to limit the noise given off by the pump.

## Patentansprüche

1. Vorrichtung zur Vakuumerzeugung, die mindestens eine Vakuumpumpe (12) enthält, die mit einer Saugleitung und einer Förderleitung (1) zusammenwirkt, **dadurch gekennzeichnet, dass** mindestens ein Anteil (1,12) der Vorrichtung zur Vakuumerzeugung durch ein Volumen (7), in dem ein geeignetes Vakuum herrscht, von der Außenatmosphäre (6) getrennt ist.

2. Vorrichtung gemäß Anspruch 1, **dadurch gekennzeichnet, dass** dieses Volumen (7), in dem ein geeignetes Vakuum herrscht, dicht ist und somit dieses geeignete Vakuum dauerhaft bewahrt.

3. Vorrichtung gemäß Anspruch 1, **dadurch gekennzeichnet, dass** dieses Volumen (7), in dem ein geeignetes Vakuum herrscht, mit einer äußeren Vakuumquelle verbunden ist, die dieses geeignete Vakuum aufrecht erhält.

4. Vorrichtung gemäß Anspruch 3, **dadurch gekennzeichnet, dass** die äußere Vakumquelle diese Vorrichtung zur Vakuumerzeugung (12) ist.

5. Vorrichtung gemäß einem der Ansprüche 1 bis 4, **dadurch gekennzeichnet, dass** dieses Volumen (7), in dem ein geeignetes Vakuum herrscht, den Raum zwischen den beiden Wänden (8, 14) einer dichten Doppelwand einnimmt.

6. Vorrichtung gemäß einem der Ansprüche 1 bis 4, **dadurch gekennzeichnet dass** dieses Volumen (7), in dem ein geeignetes Vakuum herrscht, den Raum zwischen einer dichten Außenwand (3) und diesem Anteil (1, 12) der Vorrichtung zur Vakuumerzeugung einnimmt.

7. Vorrichtung gemäß einem der Anspruche 1 bis 6 **dadurch gekennzeichnet dass** dieses Volumen (7), in dem ein geeignetes Vakuum herrscht, um die Förderleitung (1) der Vakuumpumpe herum hergestellt wird, um der Kondensation und Erstarrung der gepumpten Gase entgegen zu wirken und die Lärmemissionen zu verringern.

8. Vorrichtung gemäß Anspruch 7, **dadurch gekennzeichnet, dass** die Förderleitung (1) außerdem innere Vorrichtungen (11) zur Schalldämpfung der Druckpulsationen enthalt.

9. Vorrichtung gemäß einem der Ansprüche 1 bis 8, **dadurch gekennzeichnet, dass** dieses Volumen (7), in dem ein geeignetes Vakuum herrscht ein Saugleitungselement oder Zwischenelement in der Vorrichtung zur Vakummerzeugung umgibt.

10. Vorrichtung gemäß einem der Ansprüche 1 bis 9, **dadurch gekennzeichnet, dass** dieses Volumen (7), in dem ein geeignetes Vakuum herrscht, die Vakuumpumpe (12) umgibt. um die Lärmemission der Pumpe zu begrenzen.
